# EUROPEAN PATENT APPLICATION

(11) **EP 1 443 813 A2**
(43) Date of publication of application: **04.08.2004**
(21) Application number: 03028990.4
(22) Date of filing: 17.12.2003
(51) Int. Cl.: H05K 7/20, G06F 1/20

(54) **Electronic apparatus having heat-generating components to be cooled with liquid coolant**

(30) Priority: 31.01.2003 JP 2003023871
(71) Applicant: Kabushiki Kaisha Toshiba, Tokyo (JP)
(72) Inventor: Hisano, Katsumi, Tokyo 105-8001 (JP); Tomioka, Kentaro, Tokyo 105-8001 (JP); Kusaka, Hiroyuki, Tokyo 105-8001 (JP); Kinoshita, Teruo, Tokyo 105-8001 (JP)
(74) Representative: Henkel, Feiler & Hänzel

(57) **Abstract**

An electronic apparatus comprising a housing (2, 81), a first heat conductor (20, 85), a second heat conductor (21, 86), and a circulation path (22, 87). The housing (2, 81) contains a first heat-generating component (6, 82) and a second heat-generating component (7, 83). The first heat conductor (20, 85) and the second heat conductor (21, 86) are provided in the housing (2, 81). The first heat conductor (20, 86) is interposed between the first heat-generating component (6, 82) and the second heat-generating component (7, 83) and thermally connected to the first and second heat-generating components (6, 7, 82, 83). The second heat conductor (21, 86) faces the first heat conductor (20, 85) in the housing (2, 81). The circulation path (22, 87) circulates liquid coolant between the first heat conductor (20, 85) and the second heat conductor (21, 86).

## Description

The present invention relates to an electronic apparatus in which the heat-generating components, such as the liquid crystal display unit and the printed circuit board, are cooled with liquid coolant.

Any large, high-resolution liquid crystal display has a liquid crystal display panel, a plurality of back lights and a liquid crystal drive circuit. The back lights and liquid-crystal drive circuit generate heat while they are operating. The amount of heat that the back lights and liquid-crystal drive circuit generate is increasing as the performance of the liquid crystal display increases. Cooling systems that use air as coolant and have an electric fan device and a heat sink may not cope with the increasing amount of heat.

Recently, cooling units of so-called "liquid cooling type" have been put to trial use to cope with the increasing amount of heat. A cooling unit of this type uses liquid coolant that has specific heat much greater than that of air. Jpn. Pat. Appln. KOKAI Publication 2002-374084 discloses a cooling unit of liquid cooling type for use in electronic apparatuses such as portable computers. This cooling unit comprises a heat-receiving portion, a heat-radiating portion, and a circulation path. The heat-receiving portion is thermally connected to a semiconductor package that generates heat. The heat-radiating portion is designed to radiating the heat generated by the semiconductor package. The circulation path circulates the liquid coolant between the heat-receiving portion and the heat-radiating portion. The heat-receiving portion, heat-radiating portion and circulation path are incorporated in the housing of the electronic apparatus.

In the cooling unit of liquid cooling type, the liquid coolant absorbs heat from the semiconductor package in the heat-receiving portion. The liquid coolant thus heated is transferred to the heat-radiating portion through the circulation path. The heat absorbed into the liquid coolant propagates to the heat-radiating portion as the liquid coolant passes through the heat-radiating portion. The heat-radiating portion radiates the heat in the housing of the electronic apparatus. The liquid coolant is cooled by virtue of heat exchange performed by the heat-radiating portion. The liquid coolant thus cooled flows back to the heat-receiving portion via the circulation path and efficiently absorbs heat from the semiconductor package. As the liquid coolant is circulated, the heat is transmitted from semiconductor package to the heat-radiating portion with high efficiency. This enhances the efficiency of radiating heat from the semiconductor package.

In the conventional cooling unit of liquid cooling type, the heat-receiving portion and the heat-radiating portion are arranged in one housing, not overlapping each other. The heat-radiating portion is inevitably located in one side of the housing. No space large enough to hold the heat-radiating portion can be provided in the housing. Consequently, the heat-radiating portion needs to be small. The heat-radiating surface of the radiating portion decreases. This renders it difficult to enhance the efficiency of radiating the heat from the semiconductor package.

According to an embodiment of the present invention, there is provided an electronic apparatus comprises: a housing which contains a first heat-generating component and a second heat-generating component; a first heat conductor interposed between the first and second heat-generating components and thermally connected to the first and second heat-generating components; a second heat conductor contained in the housing and facing the first heat conductor; and a circulation path which circulates liquid coolant between the first heat conductor and the second heat conductor.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a front view of a liquid crystal display according to a first embodiment of this invention;
FIG. 2 is a back view of the liquid crystal display according to the first embodiment of the invention;
FIG. 3 is a side view of the liquid crystal display according to the first embodiment of the invention;
FIG. 4 is a sectional view of the liquid crystal display according to the first embodiment of the invention;
FIG. 5 is an expanded plan view of the cooling unit provided in the first embodiment, showing the first heat conductor, second heat conductor and circulation path of the cooling unit;
FIG. 6 is a sectional view, taken along line F6-F6 shown in FIG. 4;
FIG. 7 is a sectional view showing the junction between the first heat conductor and printed circuit board of a second embodiment of this invention;
FIG. 8 is a sectional view of a liquid crystal display according to a third embodiment of the present invention;
FIG. 9 is a back view of a liquid crystal display according to a fourth embodiment of the invention;
FIG. 10 is a sectional view of the liquid crystal display according to the fourth embodiment of the invention;
FIG. 11 is a front view of a liquid crystal display according to a fifth embodiment of this invention;
FIG. 12 is a sectional view of the liquid crystal display according to the fifth embodiment of the invention; and
FIG. 13 is a plan view of the cooling unit incorporated in the fifth embodiment, showing the first heat conductor, second heat conductor and circulation path of the cooling unit, which are all expanded.

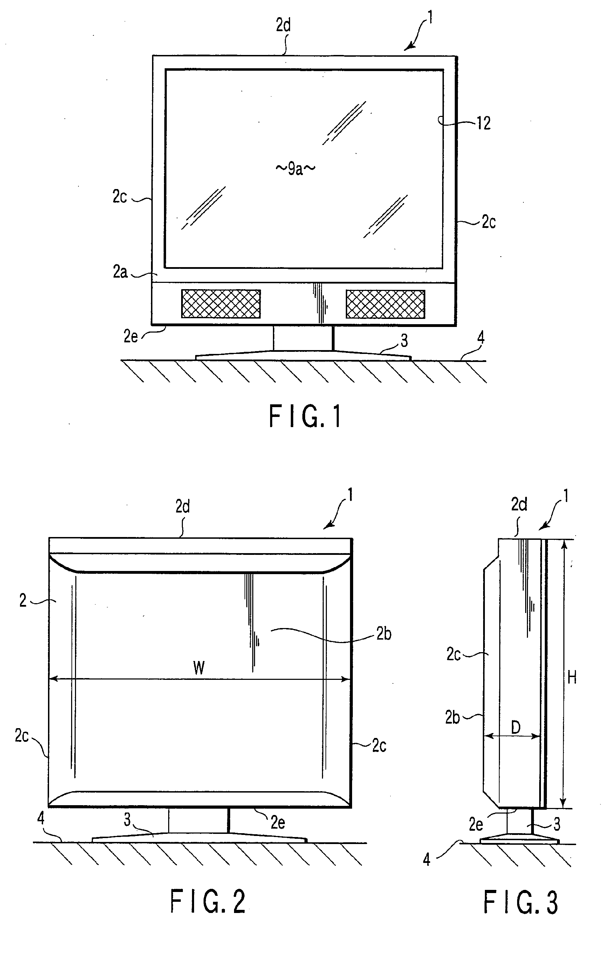

The first embodiment of the present invention will be described with reference to FIGS. 1 to 6.

FIGS. 1 to 3 show a large, high-resolution liquid crystal display 1 that is an electronic apparatus according to this invention. The liquid crystal display 1 has a flat box-shaped housing 2. The housing 2 comprises a front wall 2a, a rear wall 2b, left and right walls 2c, a top wall 2d and a bottom wall 2e. The thickness D of the housing 2 is far greater than the width W and height H of the housing 2. The housing 2 lie on a leg 3 that stands on a horizontal installation surface 4.

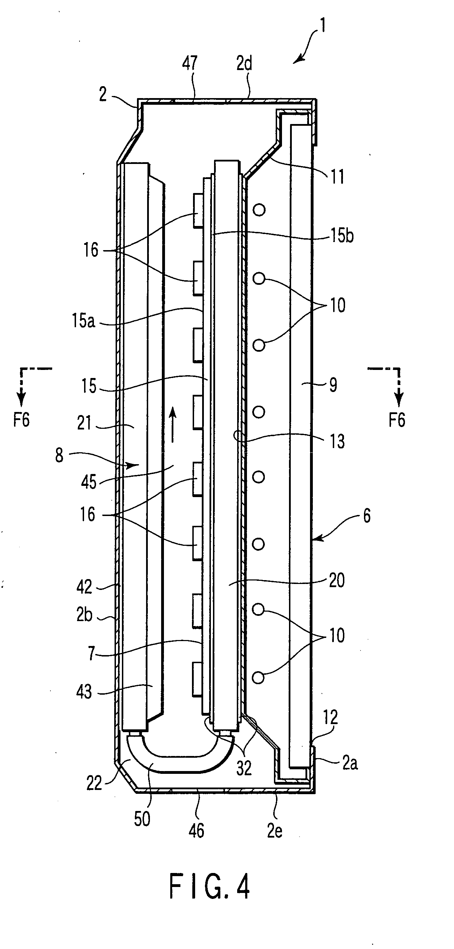

As FIG. 4 depicts, the housing 2 incorporates a liquid crystal display unit 6, a printed circuit board 7 and a cooling unit 8 of liquid cooling type. The liquid crystal display unit 6 comprises a flat liquid crystal display panel 9, back lights 10 and a frame 11. The liquid crystal display panel 9 stands upright in the housing 2. The panel 9 has a display screen 9a. The display screen 9a is exposed outside the housing 2, through the opening 12 made in the front wall 2a of the housing 2. The back lights 10 are provided near the back of the liquid crystal display panel 9. The lights 10 are arranged in a vertical row, spaced apart from one another. They generate heat while turned on. The amount of heat they generate is enormous. The frame 11 supports the liquid crystal display panel 9 and back lights 10. The frame 11 has a back plate 13 that covers the panel 9 and back lights 10 from behind. The back plate 13 is heated to high temperature, due to the heat the back light keeps generating while turned on. Namely, the liquid crystal display unit 6 is the first heat-generating component in the first embodiment.

The printed circuit board 7 stands upright and lie on the back of the liquid crystal display unit 6. The board 7 comprises a wiring board 15 and circuit parts 16. The wiring board 15 is smaller than the liquid crystal display panel 9. The board 15 has a mount surface 15a and a reverse surface 15b facing away from the mount surface 15a. The reverse surface 15b faces the back plate 13 of the frame 11. The circuit parts 16 are soldered to the mount surface 15a. Some of the circuit parts 16 generate heat while operating. Thus, the printed circuit board 7 is the second heat-generating component in the first embodiment.

The cooling unit 8 is configured to cool the liquid crystal display unit 6 and the printed circuit board 7. As seen from FIGS. 2 to 4, the cooling unit 8 comprises a first heat conductor 20, a second heat conductor 21 and a circulation path 22. The first and second heat conductors 20 and 21 function as heat-receiving portion and heat-radiating portion, respectively. The circulation path 22 extends between the first and second heat conductors 20 and 21, connecting the heat conductors 20 and 21 together.

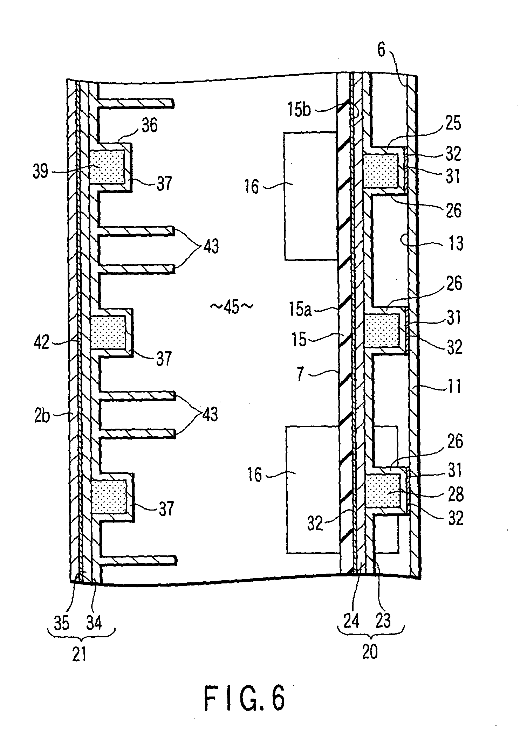

The first heat conductor 20 is interposed between the liquid crystal display unit 6 and the printed circuit board 7. The first heat conductor 20 is somewhat larger than the printed circuit board 7 and stands upright, in the direction of height of the housing 2. As FIG. 6 shows, the first heat conductor 20 comprises two heat-conducting plates 23 and 24. The plates 23 and 24 are made of metal having high thermal conductivity, such as aluminum alloy. The plates 23 and 24 are laid one upon the other.

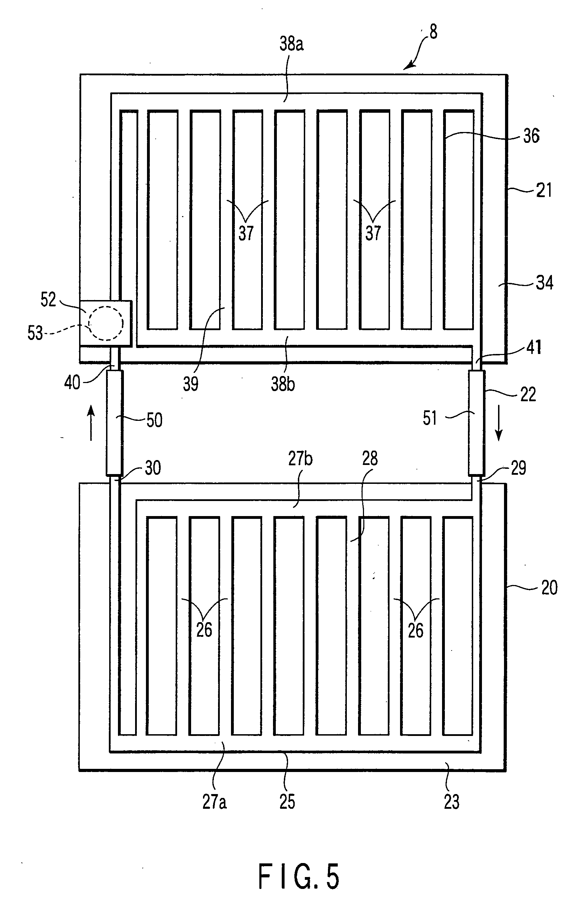

The first heat-conducting plate 23 has a bulging part 25 that swells away from the second heat-conducting plate 24. As FIG. 5 shows, the bulging part 25 has vertical passages 26 and two horizontal passages 27a and 27b. The vertical passages 26 are juxtaposed in the horizontal direction, spaced apart from one another. The horizontal passage 27a connects the upper ends of the vertical passages 26. The horizontal passage 27b connects the lower ends of the vertical passages 26. Note that FIG. 5 is an expanded plan view that represents the positional relation between the first heat conductor 20, second heat conductor 21 and circulation path 22. This is why the upper ends of the vertical passages 26 are located below the lower ends thereof, in FIG. 5.

The bulging part 25 opens to the second heat-conducting plate 24. The second heat-conducting plate 24 closes the open end of the bulging part 25. Thus, the bulging part 25 of the first heat-conducting plate 23 and the second heat-conducting plate 24 define a coolant passage 28.

The first heat conductor 20 has a coolant inlet port 29 and a coolant outlet port 30. The coolant inlet port 29 is located at the upstream end of the coolant passage 28. The coolant outlet port 30 is located at the downstream end of the coolant passage 28. The ports 29 and 30 are spaced apart in the widthwise direction of the housing 2 and project downwards from the lower edge of the first heat conductor 20.

As illustrated in FIG. 6, the bulging part 25 of the first heat-conducting plate 23 has a heat-receiving surface 31 that is flat. The heat-receiving surface 31 faces the back plate 13 of the frame 11. The second heat-conducting plate 24 faces the reverse surface 15b of the wiring board 15. A heat-conducting member 32, such as a grease layer or a thermally conductive sheet, is interposed between the heat-receiving surface 31 and the back plate 13. Another heat-conducting member 32 is interposed between the second heat-conducting plate 24 and the wiring board 15. The heat-conducting members 32 thermally connect the first heat conductor 20 to both the liquid crystal display unit 6 and the printed circuit board 7.

The second heat conductor 21 lies at the back of the first heat conductor 20, extends parallel to the first heat conductor 20 and faces the conductor 20. It is as large as the first heat conductor 20 and stands upright in the direction of height of the housing 2. As FIG. 6 shows, the second heat conductor 21 comprises a first heat-conducting plate 34 and a second heat-conducting plate 35. The heat-conducting plates 34 and 35 are made of metal having high thermal conductivity, such as aluminum alloy. The plates 34 and 35 are laid one upon the other.

The first heat-conducting plate 34 has a bulging part 36, which swells away from the second heat-conducting plate 35. As seen from FIG. 5, the bulging part 36 has vertical passages 37 and two horizontal passages 38a and 38b. The vertical passages 37 are juxtaposed in the horizontal direction, spaced apart from one another. The horizontal passage 28a connects the upper ends of the vertical passages 37. The horizontal passage 28b connects the lower ends of the vertical passages 37.

The bulging part 36 opens to the second heat-conducting plate 35. The second heat-conducting plate 35 closes the open end of the bulging part 36. Therefore, the bulging part 36 of the first heat-conducting plate 34 and the second heat-conducting plate 35 define a coolant passage 39.

The second heat conductor 21 has a coolant inlet port 40 and a coolant outlet port 41. The coolant inlet port 40 is located at the upstream end of the coolant passage 39. The coolant outlet port 41 is located at the downstream end of the coolant passage 39. The ports 40 and 41 are spaced apart in the widthwise direction of the housing 2 and project downwards from the lower edge of the second heat conductor 21.

As FIG. 6 depicts, the second heat-conducting plate 35 of the second heat conductor 21 is secured to the inner surface of the rear wall 2b of the housing 2. A heat-conducting member 42, such as a grease layer or a thermally conductive sheet, is interposed between the second heat-conducting plate 35 and the rear wall 2b of the housing 2. Therefore, the second heat conductor 21 is thermally connected to the housing 2.

The first heat-conducting plate 34 has a plurality of heat-radiating fins 43. The heat-radiating fins 43 extend along the vertical passages 37 of the bulging part 36. They extend parallel between the vertical passages 37 and are spaced apart from one another.

As shown in FIG. 4, an air passage 45 is provided in the housing 2. The air passage 45 is located between the first heat conductor 20 and the second heat conductor 21. The passage 45 extends straight in the direction of height of the housing 2. The lower end of the air passage 45 communicates with an air intake port 46 that is made in the bottom wall 2e of the housing 2. The upper end of the air passage 45 communicates with an air exhaust port 47 that is made in the top wall 2d of the housing 2. The mount surface 15a and circuit parts 16 on the printed circuit board 7 are exposed to the air passage 45. So are the first heat-conducting plate 34 and heat-radiating fins 43 of the second heat conductor 21.

The circulation path 22 is configured to circulate liquid coolant between the coolant passage 28 of the first heat conductor 20 and the coolant passage 39 of the second heat conductor 21. The liquid coolant is, for example, an antifreeze liquid prepared by adding ethylene glycol solution and, if necessary, corrosion inhibitor to water. The liquid coolant is filled in the coolant passages 28 and 39 and the circulation path 22.

As FIG. 5 shows, the circulation path 22 comprises a first pipe 50, a second pipe 51, and a pump 52. The first pipe 50 connects the coolant outlet port 30 of the first heat conductor 20 and the coolant inlet port 40 of the second heat conductor 21. The second pipe 51 connects the coolant inlet port 29 of the first heat conductor 20 and the coolant outlet port 41 of the second heat conductor 21. The pipes 50 and 51 are laid, passing below both heat conductors 20 and 21. The junction between the first pipe 50 and the first heat conductor 20 and the junction between the first pipe 50 and the second heat conductor 21 are located beneath the printed circuit board 7. Similarly, the junction between the second pipe 51 and the first heat conductor 20 and the junction between the second pipe 51 and the second heat conductor 21 are located beneath the printed circuit board 7.

Thus, the junction between the circulation path 22 and the first heat conductor 20 lies outside the upper edge of the first heat conductor 20. Likewise, the junction between the circulation path 22 and the second heat conductor 21 lies outside the upper edge of the second heat conductor 21. This prevents liquid coolant, if any leaking from any one of the above-mentioned junctions, from flowing to the printed circuit board 7 along the first heat conductor 20 or the second heat conductor 21. Leaking coolant, if any, would not do fatal damages to the printed circuit board 7.

The coolant inlet port 29 and the coolant outlet port 30 need not lie exclusively in the lower edge of the first heat conductor 20. They can be provided in, for example, upper parts of the sides of the first heat conductor 20. If this is the case, the junction between the coolant inlet port 29 and the circulation path 22 and the junction between the coolant outlet port 30 and the circulation path 22 protrude from the sides of the board 7. This is because the first heat conductor 20 is somewhat larger than the printed circuit board 7. Since both junctions protrude from the printed circuit board 7, the liquid coolant, if leaking from the junctions, will flow along the sides of the first heat conductor 20. Thus, the coolant would not wet the printed circuit board 7.

As shown in FIG. 5, the pump 52 is embedded in the second heat conductor 21. The pump 52 is provided to circulate the liquid coolant between the first heat conductor 20 and the second heat conductor 21. The pump 52 is located at the upstream end of the coolant passage 28 of the first heat conductor 20. The pump 52 has an impeller 53 for supplying the liquid coolant under a pressure. The impeller 53 starts rotating when the power switch to the liquid crystal display 1 is closed or when the temperature of the liquid crystal display unit 6 or printed circuit board 7 rises to a predetermined value.

It will be described how the heat-generating components are cooled in the liquid crystal display 1.

When the liquid crystal display 1 is turned on, the liquid crystal display unit 6 starts generating heat. At the same time, the circuit parts 16 on the printed circuit board 7 start generating heat, too. The heat-conducting members 32 conduct the heat emanating from the liquid crystal display unit 6 and the printed circuit board 7, to the first heat conductor 20. The coolant passage 28 of the first heat conductor 20 is filled with the liquid coolant. The liquid coolant absorbs most of the heat conducted to the first heat conductor 20.

In other words, the liquid coolant is heated at the first heat conductor 20. The coolant thus heated is pumped via the first pipe 50 of the circulation path 22 into the coolant passage 39 of the second heat conductor 21. Hence, the heat absorbed in the liquid coolant propagates to the heat-conducting plates 34 and 35 while the liquid coolant is flowing through the coolant passage 39. The heat-conducting plates 34 and 35 radiate the heat into the housing 2. Part of the heat conducted to the first heat-conducting plate 34 propagates via the heat-conducting member 42 to the' housing 2. The housing 2 radiates this heat into the atmosphere.

The liquid coolant is cooled by the heat exchanging performed at the second heat conductor 21. The liquid coolant, thus cooled, flows back into the coolant passage 28 of the first heat conductor 20 through the second pipe 51. The coolant again absorbs heat from the liquid crystal display unit 6 and printed circuit board 7 while it is flowing through the coolant passage 28. The coolant is thereby heated. The coolant thus heated is supplied to the second heat conductor 21 through the first pipe 50. As this cooling cycle is repeated, heat is transferred from the liquid crystal display unit 6 and printed circuit board 7 to the second heat conductor 21 and is radiated from the second heat conductor 21.

In the first embodiment of this invention, the first heat conductor 20 that receives heat and the second heat conductor 21 that radiates heat are arranged in the housing 2. They face each other and extending parallel to each other. They do not lie on the rear wall 2b of the housing 2. Nor do they lie side by side in the widthwise direction of the housing 2. Thus, they are not limited in size. That is, both heat conductors 20 and 21 can have a sufficient heat-radiating area in the limited space that is available in the housing 2. This makes it possible to cool both the liquid crystal display unit 6 and the printed circuit board 7 with high efficiency.

The first heat conductor 20 and the second heat conductor 21 face each other, across the air passage 45. The air in the passage 45 is therefore heated at both side of the air passage 45. This enhances the chimney effect. As a result, air can easily move upward in the air passage 45 as indicated by the arrow in FIG. 4. Thus, an air stream develops in the passage 45 due to natural convection. The air is discharged from the housing 2 through the air exhaust port 47 that is provided at the upper end of the air passage 45.

Hence, the heat hardly accumulates in the housing 2. Namely, the heat emanating from the liquid crystal display unit 6 and printed circuit board 7 can be efficiently expelled from the housing 2. The result is an increase in the efficiency of cooling the liquid crystal display unit 6 and printed circuit board 7.

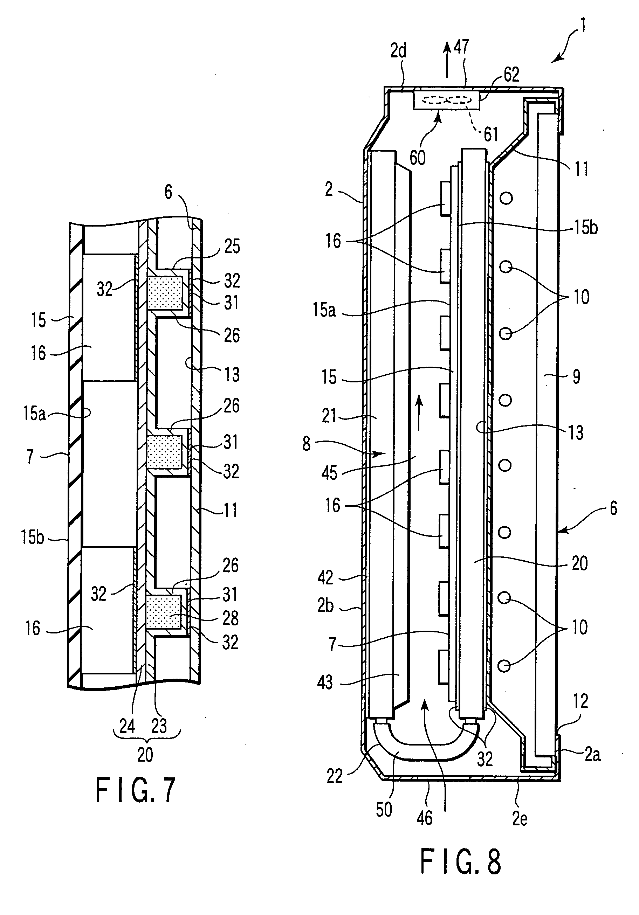

FIG. 7 shows the second embodiment of the present invention.

The second embodiment is different from the first embodiment in terms of the orientation of the printed circuit board 7. As seen from FIG. 7, the printed circuit board 7 is so positioned that the mount surface 15a of its wiring board 15 is turned upward, or to the liquid crystal display unit 6. Therefore, the first heat conductor 20 is interposed between the liquid crystal display unit 6, one the one hand, and the circuit parts 16, on the other, in the second embodiment. The heat-conducting member 32 thermally connects the circuit parts 16 to the second heat-conducting plate 24 of the first heat conductor 20.

In the second embodiment, the heat emanating from the circuit parts 16 propagates directly to the first heat conductor 20, not by way of the wiring board 15. This enables the liquid coolant to absorb heat from the circuit parts 16 with high efficiency. This ultimately enhances the efficiency of radiating heat from the printed circuit board 7.

FIG. 8 illustrates a liquid crystal display 1 according to the third embodiment of the present invention.

The third embodiment is different from the first embodiment in that the housing 2 contains an electric fan device 60. In any other structural respect, this liquid crystal display 1 is identical to the first embodiment.

As FIG. 8 shows, the fan device 60 is mounted on the inner surface of the top wall 2d of the housing 2 and opposes the air exhaust port 47. The fan device 60 has an impeller 61 and a fan case 62. The fan case 62 contains the impeller 61. The impeller 61 starts rotating when the power switch to the liquid crystal display 1 is closed or when the temperature of the liquid crystal display unit 6 or printed circuit board 7 rises to the predetermined value. While the impeller 61 is rotating, air in the air passage 45 is drawn to the air exhaust port 47 as indicated by the arrow shown in FIG. 8, and cold air is introduced into the air passage 45 from outside the housing 2 through the air intake port 46. As a result, the cooling air flows upward in the air passage 45. The air passage 45 therefore functions as passage for the cooling air.

In the housing 2, the cooling air flows from the lower end of the air passage 45 to the upper end thereof. The circuit parts 16 are exposed in the air passage 45. So are the heat-radiating fins 43 of the second heat conductor 21. The cooling air therefore effectively cools the circuit parts 16 and the second heat conductor 21. This enhances the efficiency of cooling the electric parts 16 and the second heat conductor 21. Ultimately, the efficiency of cooling the liquid crystal display unit 6 and the printed circuit board 7 increases.

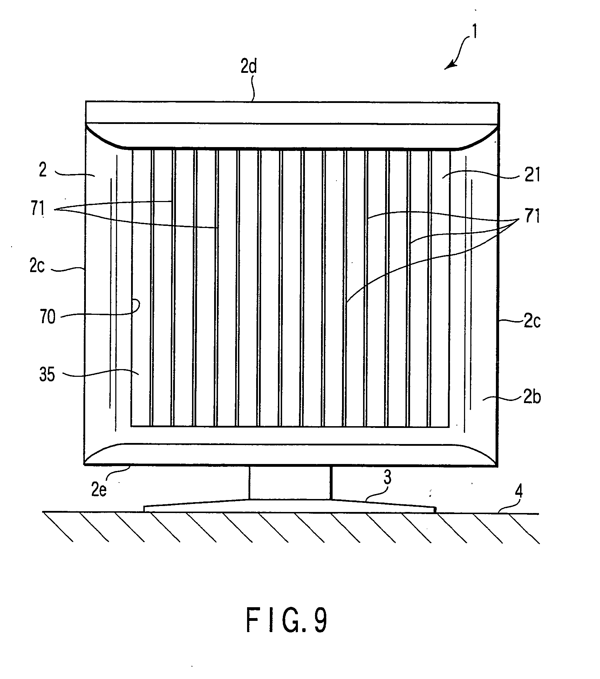

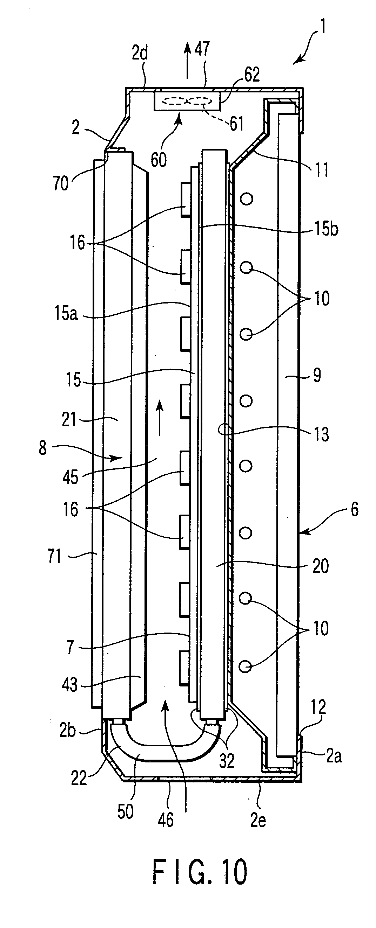

FIGS. 9 and 10 show the fourth embodiment of this invention.

The fourth embodiment is different from the third embodiment in that the second heat conductor 21 is exposed outside the housing 2. In any other structural any other structural respect, this liquid crystal display 1 according to the fourth embodiment is identical to the third embodiment.

As FIGS. 9 and 10 depict, the housing 2 has an opening 70 made in its rear wall 2b. The opening 70 is rectangular and as large as the second heat conductor 21. The second heat-conducting plate 35 of the second heat conductor 21 is exposed outside the housing 2, through the opening 70.

The second heat-conducting plate 35 has heat-radiating fins 71. The heat-radiating fins 71 extend in the direction of height of the housing 2 and are spaced apart in the widthwise direction of the housing 2. They are exposed outside the housing 2, through the opening 70.

Exposed outside the housing 2, the second heat conductor 21 contacts the air outside the housing 2. This increases the heat-radiating efficiency of the second heat conductor 21. The second heat conductor 21 therefore serves to cool the liquid crystal display unit 6 and the printed circuit board 7 with high efficiency.

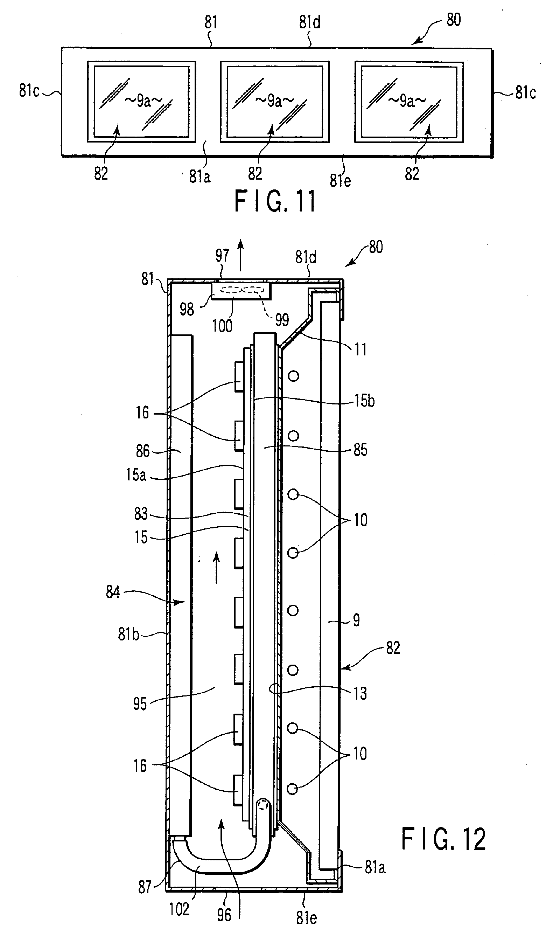

FIGS. 11 to 13 illustrates the fifth embodiment of the present invention.

The fifth embodiment is a liquid crystal display 80 that is designed for uses in monitoring systems installed in, for example, fire electric-power generating plants. The liquid crystal display 80 has a housing 81 to be laid on a wall of the central monitoring room. The housing 81 is shaped like a flat box, extending in the horizontal direction. The housing 81 comprises a front wall 81a, a rear wall 81b, left and right side walls 81c, a top wall 81d and a bottom wall 81e.

The housing 81 incorporates liquid crystal display units 82, printed circuit boards 83, and a cooling unit 84 of liquid-cooling type. The liquid crystal display units 82 are arranged in a row, at intervals and in the width direction of the housing 81. The printed circuit boards 83 stand upright, behind the liquid crystal display units 82, respectively. The display units 82 and circuit boards 83 are identical to those provided in the first embodiment. Their components identical to those of the first embodiment are designated at the same reference numerals and will not be described.

As FIGS. 11 and 12 show, the cooling unit 84 comprises heat-receiving portions 85, a heat-radiating portion 86, and a circulation path 87. The heat-receiving portions 85 are provided to receive heat from the liquid crystal display units 82, respectively. The circulation path 87 is configured to circulate liquid coolant between the heat-receiving portions 85, on the one hand, and the heat-radiating portion 86, on the other.

Each heat-receiving portion 85 is interposed between one liquid crystal display unit 82 and one printed circuit board 83 and thermally connected to the unit 82 and board 83. The heat-receiving portions 85 are rectangular plates that are somewhat larger than the printed circuit boards 83. They stand upright, in the direction of height of the housing 81.

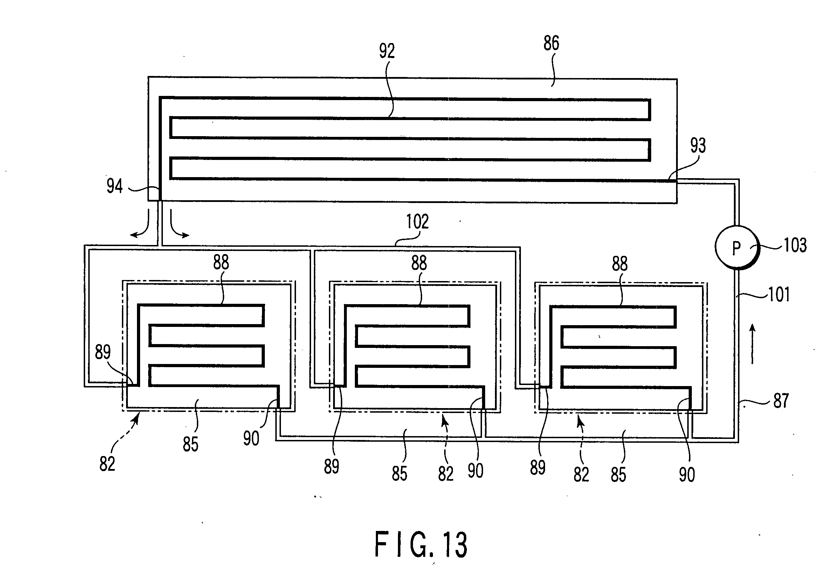

As seen from FIG. 13, each heat-receiving portion 85 has a coolant passage 88, a coolant inlet port 89, and a coolant outlet port 90. The coolant passage 88 is a meandering passage. The coolant inlet port 89 and the coolant passage 88 are provided at the upstream end and downstream end of the coolant passage 88, respectively. Both ports 88 and 89 are located at a lower part of the heat-receiving portion 85.

The heat-radiating portion 86 is provided at the back of the heat-receiving portions 85. The portion 86 faces the heat-receiving portions 85 and extends parallel to the same. The portion 86 is a rectangular plate that has a greater width than the liquid crystal display units 82. It is secured to the inner surface of the rear wall 81b of the housing 81.

The heat-radiating portion 86 has a coolant passage 92, a coolant inlet port 93, and a coolant outlet port 94. The coolant passage 92 is a meandering passage. The coolant inlet port 93 and coolant outlet port 94 are provided at the upstream and downstream ends of the coolant passage 92, respectively. Both ports 93 and 94 are located at a lower part of the heat-radiating portion 86.

As FIG. 12 depicts, an air passage 95 is provided in the housing 81. The air passage 95 lies between the heat-receiving portions 85, on the one hand, and the heat-radiating portion 86, on the other. The air passage 95 extends straight, in the direction of height of the housing 81. Its lower end communicates with an air intake port 96 made in the bottom wall 81e of the housing 81. Its upper end communicates with an air exhaust port 97 made in the top wall 81d of the housing 81.

The housing 81 contains an electric fan device 98. The fan device 98 is mounted on the inner surface of the top wall 81d of the housing 81 and opposes the air exhaust port 97. The fan device 98 has an impeller 99 and a fan case 100. The fan case 100 contains the impeller 99. The impeller 99 starts rotating when the power switch to the liquid crystal display 80 is closed or when the temperature of any liquid crystal display unit 82 or any printed circuit board 83 rises to the predetermined value. While the impeller 99 is rotating, the air in the air passage 95 is drawn to the air exhaust port 97 as indicated by the arrow shown in FIG. 12, and cold air is introduced into the air passage 95 from outside the housing 81 through the air intake port 96. As a result, the cooling air flows upward in the air passage 95, effectively cooling the heat-radiating portion 86 and the printed circuit boards 83.

As FIG. 13 shows, the circulation path 87 comprises a first pipe 101, a second pipe 102, and a pump 103. The first pipe 101 connects the coolant outlet ports 90 of the heat-receiving portions 85 in parallel to the coolant inlet port 93 of the heat-radiating portion 86. The second pipe 102 connects the coolant inlet ports 89 of the heat-receiving portions 85 in parallel to the coolant outlet port 94 of the heat-radiating portion 86. The pump 103 is provided on the first pipe 101, to supply liquid coolant under a pressure. The liquid coolant can be circulated between the coolant passages 88 of the heat-receiving portions 85, on the one hand, and the coolant passage 92 of the heat-radiating portion 86, on the other.

In the fifth embodiment, the liquid coolant circulating between the heat-receiving portions 85 and the heat-radiating portion 86 transfers the heat emanating from the liquid crystal display units 82 and printed circuit boards 83, to the heat-radiating portion 86. The heat-radiating portion 86 radiates the heat in the housing 81.

In the housing 81, the heat-receiving portions 85 face the heat-radiating portion 86 and extend parallel to the heat-radiating portion 86, as has been specified above. None of the heat-receiving portions 85 lie adjacent to the heat-radiating portion 86, in the widthwise direction of the housing 81. Thus, the heat-receiving portions 85 have a sufficient heat-receiving area, and the heat-radiating portion 86 has a sufficient heat-radiating area. The heat-receiving portions 85 and the heat-radiating portion 86 can therefore help to cool the liquid crystal display units 82 and the printed circuit boards 83 with high efficiency.

In the fifth embodiment, the heat-receiving portions 85 oppose the heat-radiating portion 86, across the air passage 95. The air in the passage 95 is therefore heated by both the heat-receiving portions 85 and the heat-radiating portion 86. This enhances the chimney effect, which promotes the natural convection in the air passage 95. As a result, hot air can easily move upward in the air passage 95. The fan device 98, which is provided in the top wall 81d, expels the hot air from the housing 81. Thus, heat hardly accumulates in the housing 81. In other words, the heat emanating from the liquid crystal display units 82 and printed circuit board 83 can be efficiently expelled from the housing 81.

In the present invention, the heat-generating components are not limited to liquid crystal display units to be provided within housings. Rather, they may be, for example, plasma display units.

## Claims

1. An electronic apparatus **characterized** comprising:
a housing (2, 81) which contains a first heat-generating component (6, 82) and a second heat-generating component (7, 83);
a first heat conductor (20, 85) interposed between the first heat-generating component (6, 82) and the second heat-generating component (7, 83) and thermally connected to the first and second heat-generating components (6, 7, 82, 83);
a second heat conductor (21, 86) contained in the housing (2, 81) and facing the first heat conductor (20, 85); and
a circulation path (22, 87) which circulates liquid coolant between the first heat conductor (20, 85) and the second heat conductor (21, 86).

2. The electronic apparatus according to claim 1, **characterized in that** the first and second heat conductors (20, 21, 85, 86) have a coolant passage (28, 39, 88, 92) each, in which the liquid coolant flows.

3. The electronic apparatus according to claim 2, **characterized in that** the first and second heat conductors (20, 21) have a first heat-conducting plate (23, 34) and a second heat-conducting plate (24, 35) each, which are laid one upon the other, and the coolant passage (28, 39) of each heat conductor (20, 21) is provided between the first and second heat-conducting plates (23, 24, 34, 35).

4. The electronic apparatus according to claim 1, **characterized by** further including an air passage (45, 95) provided in the housing (2, 81) and between the first heat conductor (20, 85) and the second heat conductor (21, 86), and **characterized in that** one of the first and second heat-generating components (6, 7, 82, 83) is exposed in the air passage (45, 95).

5. The electronic apparatus according to claim 4, **characterized by** further including a fan (60, 98) which is provided in the housing (2, 81) and supplies cooling air into the air passage (45, 95).

6. The electronic apparatus according to claim 4, **characterized in that** the first and second heat conductors (20, 21, 85, 86) stand upright and extend in a direction of height of the housing (2, 81), and the air passage (45, 95) extends in the direction of height of the housing (2, 81).

7. The electronic apparatus according to claim 6, **characterized in that** the housing (2, 81) has an air intake port (46, 96) located at a lower end of the air passage (45, 95) and an air exhaust port (47, 97) located at an upper end of the air passage (45, 95).

8. The electronic apparatus according to claim 6 or 7, **characterized in that** a junction between the first heat conductor (20, 85) and the circulation path (22, 87) is located outside an upper end of the first heat conductor (20, 85), and a junction between the second heat conductor (21, 86) and the circulation path (22, 87) is located outside an upper end of the second heat conductor (21, 86).

9. The electronic apparatus according to claim 1, **characterized in that** the first heat-generating component (6, 82) is a liquid crystal display unit (6, 82) which generates heat while operating, and the second heat-generating component (7, 83) is a printed circuit board (7, 83) which having circuit parts (16) which generate heat while operating.

10. The electronic apparatus according to any one of claims 1 to 7, **characterized in that** the circulation path (22, 87) includes a pump (52, 103) which applies a pressure on the liquid coolant to force out the same.
